(19) Europäisches Patentamt / European Patent Office / Office européen des brevets

(11) **EP 1 513 257 B1**

(12) **EUROPEAN PATENT SPECIFICATION**

(45) Date of publication and mention
of the grant of the patent:
**28.11.2007 Bulletin 2007/48**

(51) Int Cl.:
*H03L 7/099* (2006.01)    *H03L 7/18* (2006.01)
*H03L 7/087* (2006.01)

(21) Application number: **04104215.1**

(22) Date of filing: **02.09.2004**

(54) **Digital phase-locked loop circuit**

Digitale Phasenregelschleife

Boucle à verrouillage de phase numérique

(84) Designated Contracting States:
**DE FR GB**

(30) Priority: **05.09.2003 JP 2003313979**

(43) Date of publication of application:
**09.03.2005 Bulletin 2005/10**

(73) Proprietor: **Texas Instruments Incorporated
Dallas, TX 75265 (US)**

(72) Inventor: **Okita, Shigeru
166-0003 Tokyo (JP)**

(74) Representative: **Holt, Michael et al
Texas Instruments Limited
European Patents Department
800 Pavilion Drive
Northampton, NN4 7YL (GB)**

(56) References cited:
EP-A- 0 740 423    WO-A-00/04642
WO-A-94/26033    DE-C- 10 022 486
US-B1- 6 404 291

• NAKAJIMA O ET AL: "Performance improvement of all digital phase-locked loop with adaptive multilevel-quantized phase comparator" PROCEEDINGS OF THE INTERNATIONAL SYMPOSIUM ON CIRCUITS AND SYSTEMS. ESPOO, FINLAND, JUNE 7 - 9, 1988, 7 June 1988 (1988-06-07), pages 603-606, XP010069622
• SANGRIOTIS M ET AL: "DIGITAL COSTAS LOOP-LIKE PLL FOR THE CARRIER RECOVERY OF A QPSK SIGNAL" ELECTRONICS LETTERS, IEE STEVENAGE, GB, vol. 29, no. 10, 13 May 1993 (1993-05-13), pages 897-899, XP000367661 ISSN: 0013-5194

**Description**

FIELD OF THE INVENTION

The present invention pertains to a digital phase-locked loop (DPLL) circuit. More specifically, the present invention pertains to a DPLL circuit that generates a synchronizing clock at a multiple of the reference clock frequency.

BACKGROUND OF THE INVENTION

A DPLL circuit is a PLL circuit in which all parts of the loop are digitally constituted. Since it does not require a voltage-controlled oscillator (VCO), there is no need to worry about frequency drift, which is primarily a function of variations in the power source; thus, it is very stable and reliable, Also, the circuit layout is less restrictive, which is beneficial for IC design. A conventional multiplier type DPLL circuit is composed of a control oscillator made up of a frequency divider that frequency-divides at the prescribed frequency division ratio of the master clock, which has a frequency sufficiently higher than that of the input reference clock to generate an output clock, a frequency divider for feedback that frequency-divides at a frequency division ratio corresponding to the multiplier for the output clock output from said control oscillator and generates a feedback clock at a frequency equal to that of the reference clock, and a phase comparator that compares the phase of the reference clock and the feedback clock and generates a synchronization control signal for controlling the locking operation of the control oscillator. Phase locking in the control oscillator is realized with the reference clock by controlling the counter operating frequency at high speed, low speed or intermediate speed with respect to the master clock corresponding to the synchronization control signal from the phase comparator, that is, corresponding to the phase difference between the reference clock and the feedback clock.

However, the conventional DPLL circuit has the following problem. That is, when the reference clock varies and its phase difference from the feedback clock increases, the period of the output clock becomes immediately disturbed, increasing jitter. Although this phenomenon is momentary, it is still undesirable for the DPLL circuit applications, especially in the fields of audio and image processing, because an increase in jitter of the DPLL output affects recording/reproduction and transmission quality of the audio and video information. Also, in a conventional DPLL circuit, the property of the control oscillator in tracking the phase difference between the reference clock and the feedback clock or the synchronization control signal from the phase comparator is limited. In particular, the counter operating frequency has a narrow range, so that the lock range is limited, which is also undesirable.

In the context of known digital phase locked loops, the content of patent DE 10022486, which describes an arrangement with a divided input.

The present invention provides a digital phase locked loop as set forth in the claims.

In a preferred method of the present invention, said period measurement circuit has a time-measuring counter that counts the second master clock. Also, said moving average value computation circuit may have a sampling part that extracts at a prescribed shift pitch A period measurement values of the A (A is an integer of 2 or more) consecutive intermediate clock portions obtained by said period measurement circuit, and an average value computation circuit that determines the average value for said A period measurement values extracted by said sampling part. In addition, said output clock generator may have a counter for oscillation that counts the third master clock.

In another preferred method, a hold control part suspends the computation processing of said moving average value computation circuit so as to temporarily hold the output clock generated by said output clock generator constant. This hold function is especially effective when it is determined that the reference clock is disturbed or a disturbance in the reference clock can be detected.

In another preferred method, said intermediate clock generated by said second frequency divider and said output clock generated by said clock generator are inputs to a feedback control part which selects either the intermediate clock or output clock and outputs it to said first frequency divider. Said feedback control part has a phase-lock detector that detects whether the reference clock and the feedback clock are phase-locked, and said intermediate clock or said output clock is selected corresponding to the detection result of said phase-lock detector. In a preferred method, said phase-lock detector comprises the following parts: an edge detector that detects the rising edge or falling edge of said input clock as the first clock edge, and detects the rising edge or falling edge of said feedback clock as the second clock edge, a consecutive alternating input cycles counter that counts the consecutive number of cycles of alternating input of said first clock edge and said second clock edge, and a control signal output circuit that outputs a control signal for selecting said intermediate clock from a prescribed initial state until the count value of said consecutive alternating input cycles counter exceeds a prescribed value, and a control signal for selecting said output clock after the count value of said consecutive alternating input cycles counter exceeds the prescribed value. This method includes a counter control unit that resets the count value of said consecutive alternating input cycles counter to the initial value when the alternating input of said first clock edge and said second clock edge is not established.

In another preferred method a frequency-lock detector compares the period measurement value with said period measurement circuit and the moving average value obtained by said moving average value computation circuit to detect whether the frequency lock state has been established, and said intermediate clock or said output clock is selected corresponding to the detection result of said frequency-lock detector. In this way, in the feedback control part, not only phase-locking but also frequency-locking are checked to perform switching from the intermediate clock to the output clock. As a result, the overall control of the phase-locked loop can be made even more reliable.

The second digital phase-locked loop circuit of the present invention is a digital phase-locked loop circuit for generating a locked output clock at a frequency M-times (where M is an integer of 2 or more) that of the input prescribed reference clock and comprises the following parts: a first frequency divider that divides the frequency of said output clock to 1/M to generate a feedback clock, a first phase comparator that compare the phases of said input reference clock and said feedback clock and generates a first synchronization control signal corresponding to the phase difference, a second frequency divider that divides the first master clock to 1/N (where N is an integer of 2 or more) according to the first synchronization control signal obtained by said first phase comparator and generates an output clock at a frequency M-times that of said reference clock, a second phase comparator that compares the phase of said reference clock and said feedback clock to generate a second synchronization control signal corresponding to the phase difference, and a frequency division ratio control part that controls and adjusts frequency division ratio N of said second frequency divider corresponding to the second synchronization control signal obtained by said second phase comparator.

In said second digital phase-locked loop circuit, the operation of the second phase comparator and the frequency division ratio control part adjusts and controls the frequency division ratio N of the second frequency divider in accordance with the phase difference between the reference clock and the feedback clock, so that the output frequency range of the second frequency divider for maintaining phase-locking, that is, the lock range, can be wider.

As a preferred method of the present invention, said second phase comparator detects the phase difference between said reference clock and said feedback clock at a sensitivity lower than that of said first phase comparator. More preferably, a second synchronization control signal is output when the phase difference between the reference clock and the feedback clock exceeds the prescribed range. In a preferred method, said frequency division ratio control part has a range counter that sets the reference frequency division ratio as the count initial value for said second frequency divider, and adjusts the count value corresponding to said second synchronization control signal from said second phase comparator.

The constitution of the second phase comparator and frequency division ratio control part in said second digital phase-locked loop circuit may be the same as that of said first digital phase-locked loop circuit. It is then possible, through a synergistic effect to further reduce output jitter and to improve tracking ability.

In a preferred method, the second frequency divider of both said first and second digital phase-locked loop circuits may have a counter for frequency division that counts the first master clock at the counter operating frequency corresponding to the first synchronization control signal from the first phase comparator. In a more preferred method, the second frequency divider may have a 1-bit counter that counts said first master clock at the counter operating frequency corresponding to the first synchronization control signal from said first phase comparator, and a pre-scaler that counts the clock output from said 1-bit counter and generates said intermediate clock. Here, in a preferred method, the 1-bit counter has the following count modes: a first count mode that counts one for every two clocks of said first master clock, a second count mode that counts three for every four clocks of said first master clock corresponding to the first synchronization control signal from said first phase comparator, which represents the phase delay of said feedback clock with respect to said reference clock, and a third count mode that counts one for every four clocks of said first master clock corresponding to the first synchronization control signal from said first phase comparator, which represents the phase advance of said feedback clock with respect to said reference clock. In this case, if the frequency of the first master clock is fm, in the first count mode, the first master clock is counted at a counter operating frequency of fm/2; in the second count mode, the first master clock is counted at a counter operating frequency of fm/4; and in the third count mode, the first master clock is counted at a counter operating frequency of 3fm/4.

Other aspects of the present invention are as follows:-

A digital phase-locked loop circuit characterized by the fact that it has a counter control unit that resets the count value of said consecutive alternating input cycles counter when alternating said first clock edge and said second clock edge inputs are not established.

BRIEF DESCRIPTION OF THE DRAWINGS

FIG. 1 is a block diagram illustrating the constitution of the DPLL circuit in Embodiment 1 of the present invention.
FIG. 2 is a block diagram illustrating an example of the circuit constitution of the up/down counter in the DPLL circuit of Embodiment 1.

FIG. 3 is a timing diagram illustrating the operation of the up/down counter in the DPLL circuit of Embodiment 1.

FIG. 4 is a timing diagram illustrating the operation of the various parts in the phase-locked loop in the DPLL circuit in Embodiment 1.

FIG. 5 is a timing diagram illustrating an example of the operation in which the feedback signal is switched in the DPLL circuit of Embodiment 1.

FIG. 6 is a block diagram illustrating an example of the circuit constitution of the phase-lock detector in the DPLL circuit of Embodiment 1.

FIG. 7 is a diagram illustrating an example of state transitions of the phase-lock detector in Embodiment 1.

FIG. 8 is a timing diagram illustrating the operation of the phase-lock detector in the DPLL circuit of Embodiment 1.

FIG. 9 is a block diagram illustrating the constitution of the DPLL circuit in Embodiment 2.

FIG. 10 is a timing diagram illustrating the operation of the various parts of the phase-locked loop in the DPLL circuit of Embodiment 2.

REFERENCE NUMERALS AND SYMBOLS AS SHOWN IN THE DRAWINGS

In the figures, 10 represents a phase comparator, 12 represents a control oscillating part, 14 represents a feedback part, 16 represents a feedback frequency divider, 18 represents an intermediate oscillating frequency divider, 20 represents a period measurement circuit, 22 represents a moving average value computation circuit, 24 represents an output clock generator, 26 represents a master clock generator, 28 represents an up/down counter, 30 represents a pre-scaler, 38 represents a phase-lock detector, 40 represents a clock selecting circuit, 52 represents a hold control part, 54 represents a phase comparator, 56 represents a range counter, 58 represents a frequency-lock detection.

DESCRIPTION OF THE EMBODIMENTS

The digital phase-locked loop (DPLL) circuit of the present invention with the aforementioned constitution and functions makes it possible to reduce output jitter and obtain a stable synchronizing clock; it is also possible to improve the tracking ability of the control oscillation part and expand the lock range.

In the following, preferred embodiments of the present invention will be explained with reference to appended figures.

EMBODIMENT 1

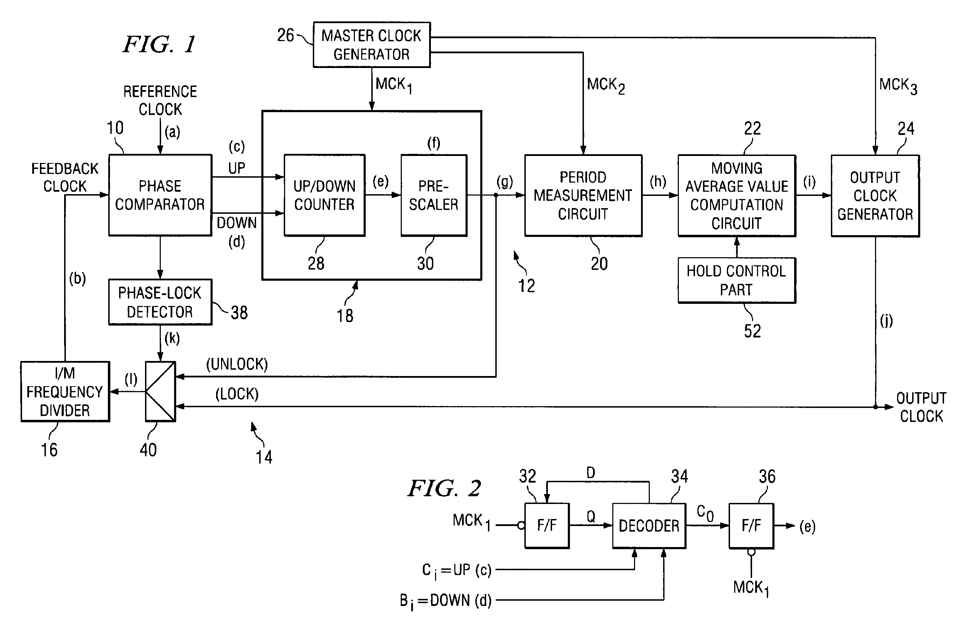

FIG. 1 is a diagram illustrating the constitution of the digital phase-locked loop (DPLL) circuit in Embodiment 1 of the present invention. The DPLL circuit of this embodiment is a multiplier DPLL circuit that generates locked output clock j at a frequency M-times (where M is an integer of 2 or larger) that of input reference clock a. Generally speaking, it is has a phase-locked loop composed of phase comparator 10, control oscillation part 12 and feedback part 14.

Feedback part 14 contains frequency divider 16 that generates feedback clock b at 1/M times the frequency division of output clock j. Phase comparator 10 compares the phase of reference clock a and feedback clock b, and outputs digital synchronization control signals c, d corresponding to the phase difference. More specifically, from the difference in time between the edge of reference clock a and the edge of feedback clock b, the lead/lag relationship or phase difference between the two clocks is detected, and either up-count enable signal c or down-count enable signal d of the square wave pulse is selected and output corresponding to the lead/lag relationship during the period from the edge of the leading clock to the edge of the lagging clock. Here, said up-count enable signal c is output when feedback clock b lags reference clock a. On the other hand, down-count enable signal d is output when feedback clock b leads reference clock a.

Control oscillation part 12 includes frequency divider 18, period measurement circuit 20, moving average value computation circuit 22, and output clock generator 24. Master clocks MCK1, MCK2, and MCK3 from master clock generator 26 are input to frequency divider 18, period measurement circuit 20, and output clock generator 24, respectively.

Frequency divider 18 is a pre-oscillator or intermediate oscillator. It is composed of up/down counter 28 and pre-scaler 30. Said up/down counter 28 is composed of 1-bit counters that count master clock MCK1 according to synchronization control signals c, d from phase comparator 10.

For example, as shown in FIG. 2, up/down counter 28 has D-type flip-flop circuit 32 and decoder 34. Flip-flop circuit 32 retrieves and latches operation output D of decoder 34 at the clock timing of master clock MCK1, that is, the falling edge. Decoder 34 is an adder, into which is input the latched output from flip-flop circuit 32 and up-count enable signal c and down-count enable signal d from phase comparator 10 as carry-in $C_i$ and borrow $B_i$ respectively. It performs the following addition operation, and outputs arithmetic operation result D and carry-out $C_0$. Flip-flop circuit 36 in the output section latches carry-out $C_0$, delays it by 1 clock, and then outputs it as counter output e. When carry-out $C_0$ is

output unmodified as counter output e, said flip-flop circuit 36 is omitted.

$$D = (Q + C_1 - B_1 + 1) \% 2 \quad \cdots \quad (\text{2's complement arithmetic})$$
$$C_0 = 1 \quad (C_1 = 1, \ B_1 = 0)$$
$$= 0 \quad (C_1 = 0, \ B_1 = 1)$$
$$= Q \quad (C_1 = 0, \ B_1 = 0)$$

In the above arithmetic equation for D, 2% stands for twos complement arithmetic. The remainder obtained by dividing the value in parenthesis by 2 corresponds to D. Also, it is assumed that carry-in $C_i$ (up-count enable signal c) and borrow $B_i$ (down-count enable signal d) cannot be "1" at the same time. That is, as explained above phase comparator 10 either outputs both, up-count enable signal c and down-count enable signal d, but not at the same time, or only one enable signal.

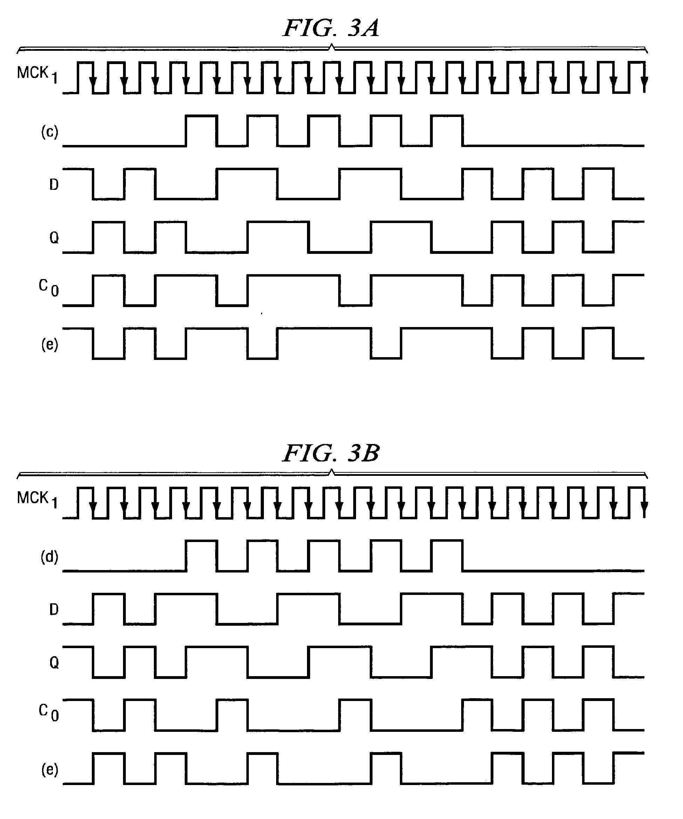

FIGS. 3A, B show the signal waveforms of the various portions in up/down counter 28 when up-count enable signal c or down-count enable signal d are output as synchronization control signals from phase comparator 10. As far as the relationship between master clock MCK1 and carry-out $C_o$ is concerned, during the period when neither up-count enable signal c nor down-count enable signal d is output, carry-out $C_o$ becomes "1" in one out of two periods of master clock MCK1. That is, in this case, up/down counter 28 counts one for every two clocks of master clock MCK1. On the other hand, during the period when up-count enable signal c is output, up/down counter 28 counts three for every four clocks of master clock MCK1, and carry-out $C_o$ is "1" in three out of four periods of master clock MCK1. Also, during the period when down-count enable signal d is output, up/down counter 28 counts one for every four clocks of master clock MCK1, and carry-out $C_o$ is "1" in one out of four periods of master clock MCK1.

In this way, up/down counter 28 performs the counting operation at a counting frequency of fm/4~3fm/4 for peak-to-peak with respect to frequency fin of master clock MCK1. Especially, when feedback clock b leads reference clock a, the counting operation is performed in the up-count mode of 3fm/4 corresponding to up-count enable signal c from phase comparator 10. On the other hand, when feedback clock b lags reference clock a, the counting operation is performed in the down-count mode of fm/4 corresponding to down-count enable signal d from phase comparator 10.

As shown in FIG. 1, pre-scaler 30 is formed as a 1-bit counter with the following operation: output e of up/down counter 28 is retrieved at the clock timing of master clock MCK1, and only when e is "1" is count value f counted up for one, and when count value f reaches preset value P, the logic value of output g is inverted. For example, when master clock MCK1 is frequency divided to 1/N in frequency divider 18, the half-value Ns/2 of reference frequency division ratio Ns is given as preset value P to pre-scaler 30. During the period of counting of count value f from initial value 0 to preset value P, pre-scaler 30 outputs intermediate clock g of one cycle. Consequently, the period of intermediate clock g output from pre-scaler 30 varies corresponding to output e of up/down counter 28. That is, during the period when up/down counter 28 is in steady-state operating mode of counter operating frequency fm/2, the period of intermediate clock g is kept at the reference period of a steady value (constant value), and the period of intermediate clock g generated when up/down counter 28 operates in the up-count mode at counter operating frequency of 3fm/4 becomes shorter than the reference period. The period of intermediate clock g generated when up/down counter 28 operates in the down-count mode at counter operating frequency of fm/4 becomes longer than the reference period.

Period measurement circuit 20 contains a counter for time measurement that operates at master clock MCK2, and as explained above, it measures the time with a period of each intermediate clock g output from pre-scaler 30 taken as count value h. Consequently, for example, when a certain period of intermediate clock g is equal to said reference period, time-measuring count value h equal to said reference frequency division ratio Ns is obtained by period measurement circuit 20 with respect to one period.

Moving average value computation circuit 22 retrieves the period measurement values obtained successively by period measurement circuit 20 for a period of each clock g output from pre-scaler 30 as time-measuring count values h, and computes moving average value i. Typically, A (where A is an integer of 2 or more) consecutive period measurement values h of intermediate clock g obtained from period measurement circuit 20 are sampled, and the average value of the A period measurement values h is determined. On the time axis, the sampling range is shifted at a prescribed shifting pitch, and the aforementioned average value computation is carried out repeatedly, and each average value obtained in time sequence is output as moving average value i. Although the value of the shifting pitch can be selected as desired, it is usually set to "1", and the sampling for each cycle is performed in the form of picking one period measurement value (h) at the head and one period measurement value (h) at the tail on the time axis in turn. Also, the same function can be realized by means of a lowpass filter.

Output clock generator 24 is a control oscillator of the output section. It contains a counter that counts master clock MCK3, with moving average values i given successively from moving average value computation circuit 22 as preset values, and generates output clock i with each moving average value i used as the period.

As shown in FIG. 1, master clocks MCK1, MCK2, MCK3 from master clock generator 26 are sent to intermediate oscillating frequency divider 18, period measurement circuit 20, and output clock generator 24, respectively. The other parts in this DPLL circuit, that is, phase comparator 10, feedback frequency divider 16, moving average value computation circuit 22, phase-lock detector 38, etc. operate with the same master clock or the basic clock.

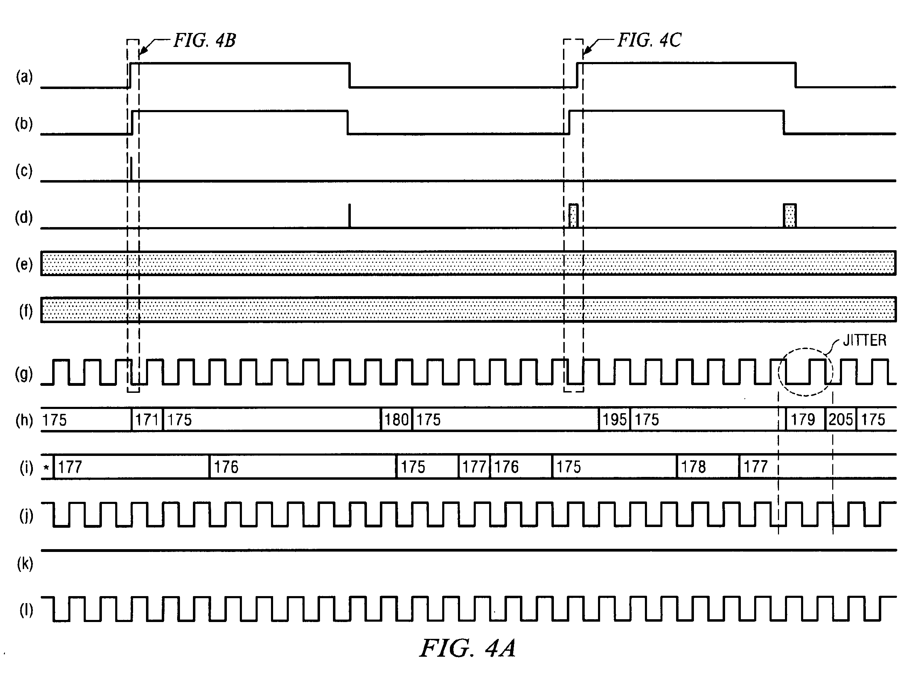

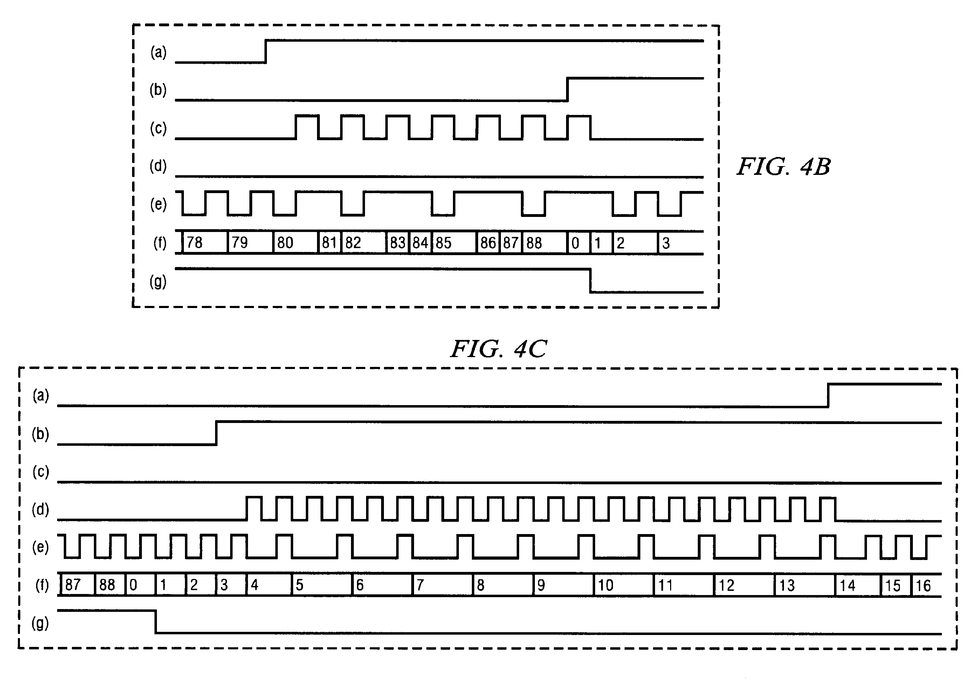

FIG. 4 is a timing diagram illustrating the functions of the various parts of said phase-locked loop of said DPLL circuit. In this example, frequency division ratio M of feedback frequency divider 16 is set to "14", and preset value P of pre-scaler 30 of intermediate oscillating frequency divider 18 is set to "89".

As explained above, phase comparator 10 compares the phase between the corresponding edges (rising edges or falling edges) of reference clock a and feedback clock b, and, corresponding to the phase difference, either up-count enable signal c or down-count enable signal d is selected and output.

In the case of FIG. 4A (B), as shown in an enlarged view in FIG. 4B, feedback clock b lags reference clock a; during the period from the rising edge of reference clock a to the rising edge of feedback clock b, up-count enable signal c is repeatedly output from phase comparator 10 at 1/2 the frequency of master clock MCK1 (fm/2). As a result, the counting speed of up/down counter 28 and pre-scaler 30 of intermediate oscillating frequency divider 18 increases, and the period of intermediate clock g decreases. In the example shown in the figure, the period of intermediate clock g measured by period measurement circuit 20, which is "177" immediately before the phase comparison is performed, is reduced to "171" corresponding to the phase comparison result.

In the case of FIG. 4A (C), as shown in an enlarged view in FIG. 4C, feedback clock b leads reference clock a; during the period from the rising edge of feedback clock b to the rising edge of reference clock a, down-count enable signal c is repeatedly output from phase comparator 10 at 1/2 the frequency of master clock MCK1 (fm/2). As a result, the counting speed of up/down counter 28 and pre-scaler 30 of intermediate oscillating frequency divider 18 decreases, and the period of intermediate clock g increases. In the example shown in the figure, the period of intermediate clock g, which is "175" immediately before the phase comparison is performed, is increased to "195" corresponding to the phase comparison result.

In this way, in intermediate oscillating frequency divider 18, as a result of tracking synchronization control signals c, d from phase comparator 10, the period of intermediate clock g fluctuates widely. However, the wide variation in the period of intermediate clock g is relieved by calculating the moving average with shift value computation circuit 22, so that it appears as a small variation in moving average value i. In the example shown in FIG. 4, while the period of intermediate clock g varies with a magnitude of about $\pm 5 \sim 30$, moving average value i varies slightly with a fluctuation magnitude of about $\pm 1 \sim 3$. As a result, output clock j obtained from output clock generator 24 can track reference clock a slowly and reliably. Consequently, even when reference clock a varies and the phase difference with respect to feedback clock b increases, there is still no significant increase in the output jitter, and the phase-locked state can be maintained stably.

In this embodiment, clock selection circuit 40 is set in feedback part 14. Output clock j from output clock generator 24 and intermediate clock g from intermediate oscillating frequency divider 18 are input to clock selection circuit 40. Under control of phase-lock detector 38, either clock j or clock g is selected and sent to feedback frequency divider 16. In this DPLL circuit, when the phase-locked state is not established, a brief time is required before the period of output clock j, which is defined by a moving average established. Consequently, the time for feeding back the intermediate clock g with a high response sensitivity can be shorter than that for feedback of output clock j with a low response sensitivity.

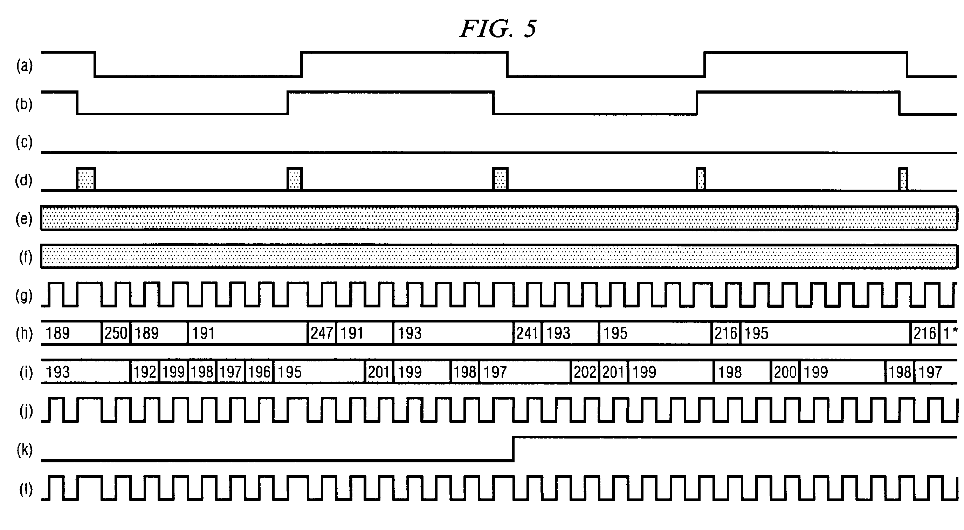

FIG. 5 is a diagram illustrating an example of clock selection or switching in clock selecting circuit 40. As shown in the figure, when the control signal from phase-lock detector 38, that is, clock selection signal k, has logic value L, the phase-lock state has not yet been established, and clock selecting circuit 40 selects intermediate clock g. Once the phase-lock state is established, clock selection signal k changes from logic value L to logic value H, and clock selecting circuit 40 selects output clock j. In the example shown in FIG. 5, reference frequency division ratio Ns in intermediate oscillating frequency divider 18 and pre-scaler present value P are different from those in FIG. 4.

When this DPLL circuit is designed, for example, so that phase-locking occurs at the rising edges of reference clock a and feedback clock b, the phase difference between reference clock a and feedback clock b will be within the range of $\pm 180°$ as long as the rising edge of reference clock a and the falling edge of feedback clock b are input alternately and repeatedly. A prescribed amount of time is required to establish an appropriate phase comparison. As will be explained below, in phase-lock detector 38 of this embodiment, the consecutive number of cycles with alternating and repeated rising edges of reference clock a and falling edges of feedback clock b are counted, and the output signal, that is, clock selection signal k, is kept at logic value L (clock selection circuit 40 selects intermediate clock g until the count value exceeds a preset value). Once the count value exceeds the preset value, clock selection signal k goes to logic value H (clock selecting circuit 40 selects output clock j).

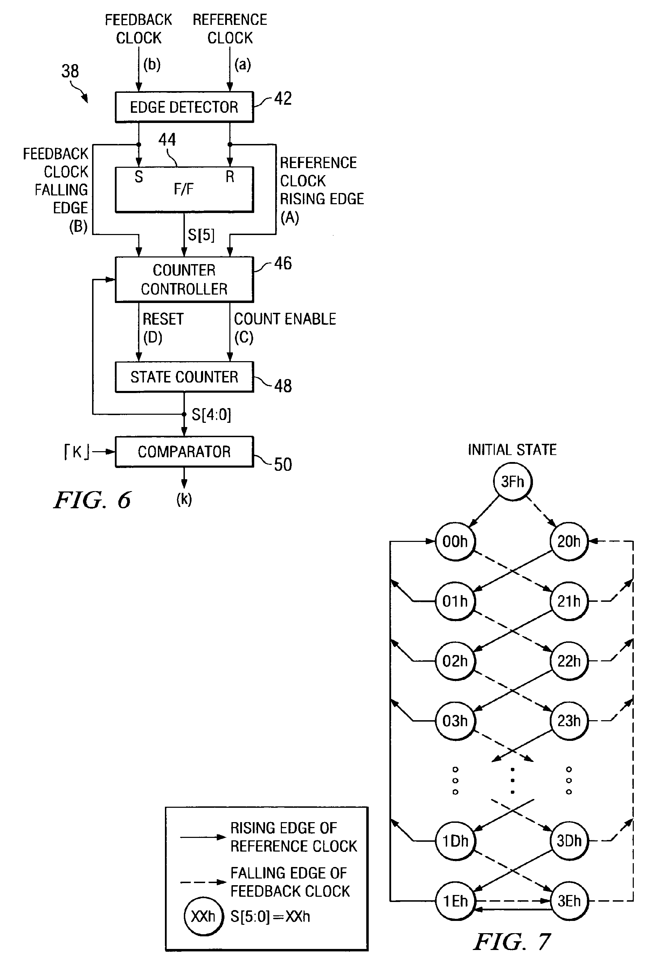

FIG. 6 is a diagram illustrating an example of the constitution of phase-lock detector 38. Phase-lock detector 38 includes edge detector 42, RS flip-flop circuit 44, counter controller 46, state counter 48, and comparator 50. Reference clock a and feedback clock b are input to edge detector 42, which detects the rising edge input of reference clock a and falling edge input of feedback clock b. Edge detector 42 includes a pair of outputs A, B. During the period when neither the rising edge of reference clock a nor the falling edge of feedback clock b is input, A = L, B = L. When the rising edge of reference clock a is detected, A = H, B = L. When the falling edge of feedback clock b is detected, A = L, B = H.

RS flip-flop circuit 44 latches outputs a, b of edge detector 42 and holds the following logic values: L for output S[5] when A = H and B = L; H for output S[5] when A = L and B = H; and the logic value for S[5] when A = L and B = L. While output S[5] of RS flip-flop circuit 44 is used as a reference for a flag that records or holds the preceding clock edge input, counter controller 46 retrieves outputs a, b of edge detector 42, and each time the output A = L and B = H appears alternately between the output A = L, B = L and the output A = H, B = L, the 5-bit count value S[4:0] of state counter 48 is incremented by one. Comparator 50 holds the comparison output signal, that is, clock selection signal k at L until count value S[4:0] of state counter 48 exceeds preset value K, and when count value S[4:0] exceeds preset value K, clock selection signal k goes to H. That is, when the rising edge input of reference clock a and the falling edge input of feedback clock b alternate consecutively for K cycles, the determination is made that the phase-locked state is established, and clock selection signal k is switched from L to H. On the other hand, when the output A = H, B = L or the output A = L, B = H occurs twice consecutively with the output of A = L, B = L between them, counter controller 46 resets state counter 48, and count value S[4:0] returns to the initial value "00000".

FIG. 7 shows an example of a state transition of phase-lock detector 38. The 1-bit output S[5] (preceding clock edge input hold flag) of RS flip-flop circuit 44 and the 5-bit output S[4:0] (consecutive number of cycles with alternating clock edge inputs) of state counter 48 are merged to form 6-bit state information S[5:0] that is represented as a hexadecimal number. As shown in FIG. 7, for example, when the state information S[5:0] is "02h", it is "0000010" in binary representation, and S[5]=0, S[4:0]=00010. In this state, when the falling edge input of feedback clock b is detected, S[5]=1, S[4:0]=00011, and the state information S[5:0] makes a transition to "00100011 ", that is, "23h". However, in this state, when the rising edge input of reference clock a is detected, the alternating input of the clock edges is not established. With S[5]=0 as is, output S[4:0] of state counter 48 is initialized to "00000", and state information S[5:0] returns from "02h" to "00000000", that is, "00h". Also, the initial value of "3Fh" is an example.

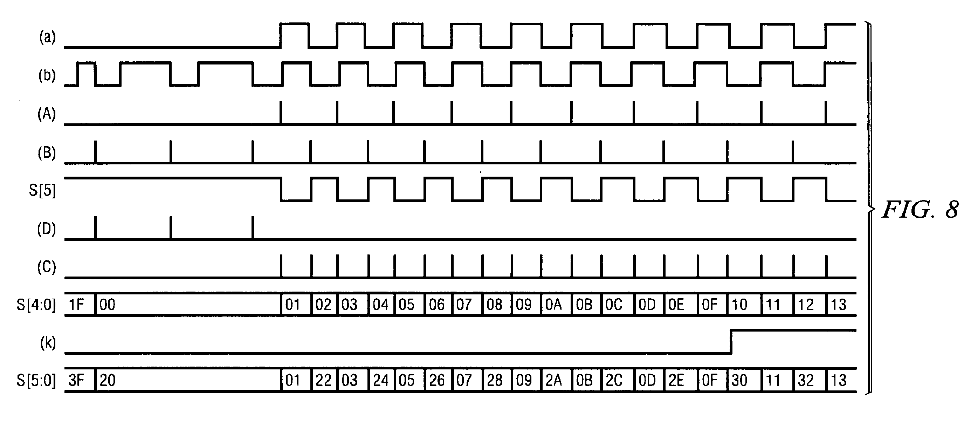

FIG. 8 is a timing diagram illustrating the operation of phase-lock detector 38. In this example, preset value K with respect to state counter 48 is set at "0Fh", and at the time when count value S[4:0] of state counter 48 exceeds "0Fh", clock selection signal k is switched from L to H. Also, count value S[4:0] is represented as a hexadecimal number.

As shown in FIG. 8, during the period when reference clock a is not input, edge detector 42 outputs A = L, B = H at each falling edge of feedback clock b, state counter 48 is reset by counter controller 46, and the count value S[4:0] is kept at the initial value "00h". Also, output S[5] of flip-flop circuit 44 is kept at H. When the input of reference clock a begins, the rising edge of input reference clock a and the falling edge of input feedback clock b appear alternately and repeatedly, the logic value of preceding clock edge input hold flag S[5] is inverted, and, at the same time, the count value S[4:0] is incremented by one so that "01h" → "02h" → "03h" →... Then, when count value S[4:0] reaches "10h", that is, when S[4:0] > preset value "0Fh", clock selection signal k is switched from L to H.

In the aforementioned example, the rising edge of reference clock a and the falling edge of feedback clock b are combined, and the alternating input of the clock edges is monitored. However, it is also possible to have a combination of the falling edge of reference clock a and the rising edge of feedback clock b. Also, when the design is such that phase-locking occurs between the rising edge of either reference clock a or feedback clock b and the falling edge of the other clock, said alternating inputs with a combination of the rising edges or a combination of the falling edges of said two clocks a, b may also be monitored.

In practical applications, disturbances in reference clock a are determined beforehand, or disturbance in reference clock a may be determined. For example, applications of DVD (digital versatile disc) or other optical disk devices in which the wobble signal is used as the reference clock and its multiplier M synchronization clock is generated, may required that the wobble signal be ignored in defective portions of discs with defective wobble, and also that the period of the synchronization clock have as little disturbance as possible. Hold control part 52 is arranged in the DPLL circuit of this embodiment. In this case, a defect signal is input to hold control part 52 as a hold instruction signal, so that hold control part 52 can stop the arithmetic operations of moving average value computation circuit 22, and the moving average value i is held. As a result, the period of output clock j generated by output clock generator 24 is held at the period immediately before the defect signal is given. For reasons of stability, it is preferred that during the hold time clock selecting circuit 40 of feedback part 14 select the side of output clock j. When the defect signal is released, hold control part 52 starts the arithmetic operation of moving average value computation circuit 22 again.

EMBODIMENT 2

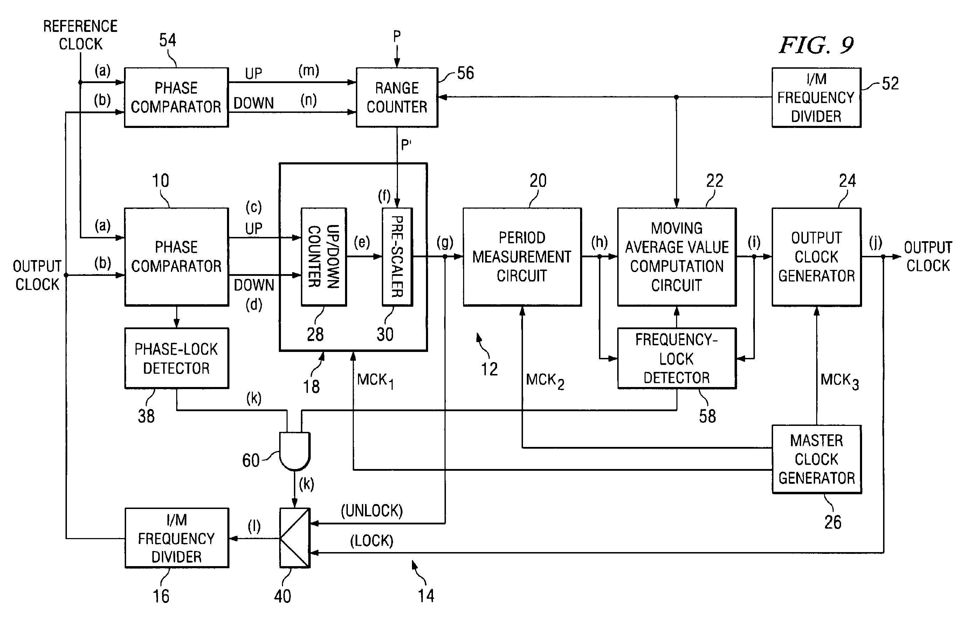

FIG. 9 is a diagram illustrating the constitution of the DPLL circuit in Embodiment 2. Part numbers used in Embodiment 1 (FIG. 1) that correspond to parts with the same constitutions and functions are used here. The most significant characteristic feature of Embodiment 2 is that phase comparator 54 and range counter 56 improve lock range.

Like phase comparator 10, phase comparator 54 compares the phase of reference clock a and feedback clock b, and corresponding to the phase difference, outputs digital synchronization control signals m, n. The phase comparator has a lower phase difference detection sensitivity than phase comparator 10, and when the phase difference between the two clocks a, b exceeds a prescribed upper limit (e.g., 1/8 of a period), corresponding to the lead/lag relationship between the two clocks, it selectively outputs either up-count enable signal m or down-count enable signal n of the square wave pulse. Here, said up-count enable signal m is output when feedback clock b leads reference clock a and the phase difference exceeds the upper limit. On the other hand, said down-count enable signal n is output when feedback clock b lags reference clock a and the phase difference exceeds the upper limit. Said upper limit may be for the phase difference obtained in a single phase comparison cycle, or it may be for the accumulated value or the moving average value of the phase difference obtained by means of several phase comparison cycles. Consequently, output signal m, n of phase comparator 54 are not abrupt, and in many cases, even if either of up-count enable signal c or down-count enable signal d is output from phase comparator 10, neither up-count enable signal m nor down-count enable signal n will be output from phase comparator 54 if the phase difference between the two clocks a, b does not exceed the upper limit.

Said up-count enable signal m or down-count enable signal n output from phase comparator 54 is sent to range counter 56. Range counter 56 functions as a frequency division ratio control part of frequency divider 18. Preset value P (a constant value) output to pre-scaler 30 of intermediate oscillating frequency divider 18 in Embodiment 1 is set as the initial value or reference value, and said up-count enable signal m and down-count enable signal n from phase comparator 54 initiate up-counting and down-counting respectively, and reference value P is increased/decreased to generate count value P'. This count value P' is sent as corrected preset value to pre-scaler 30.

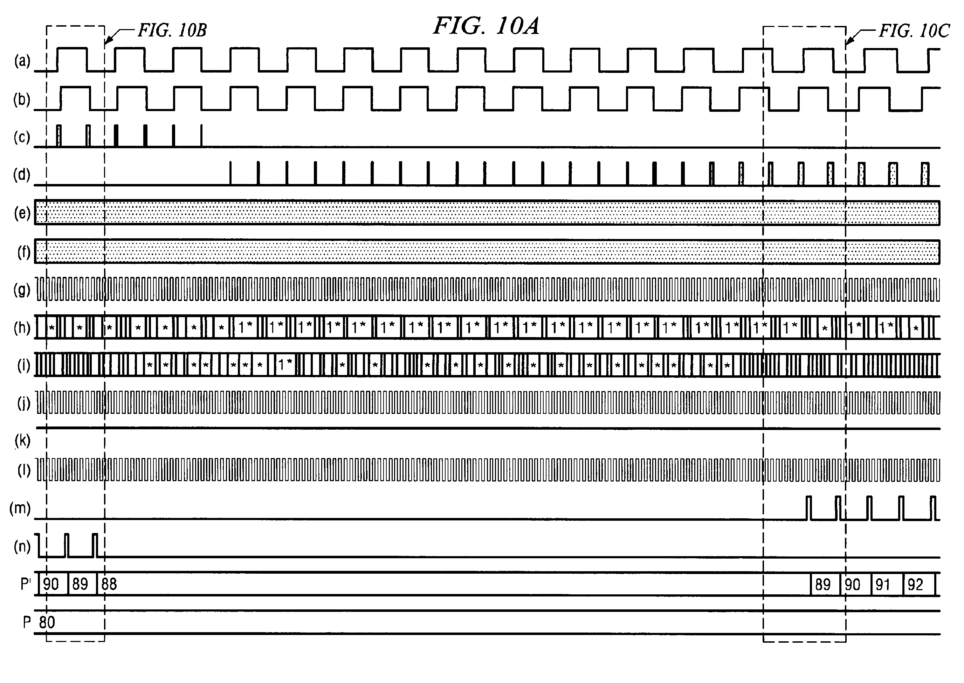

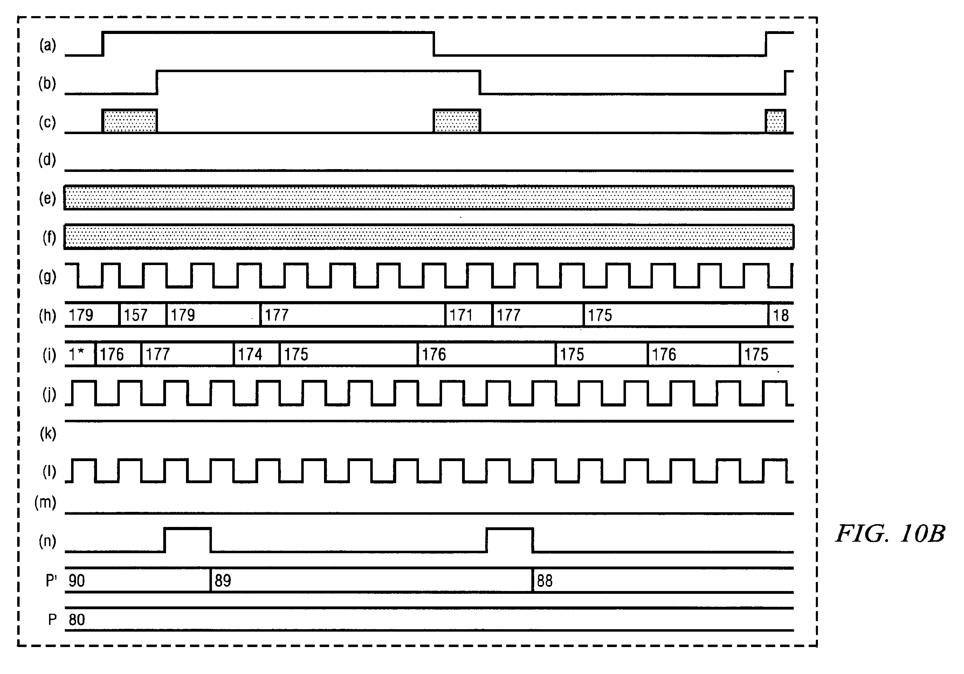

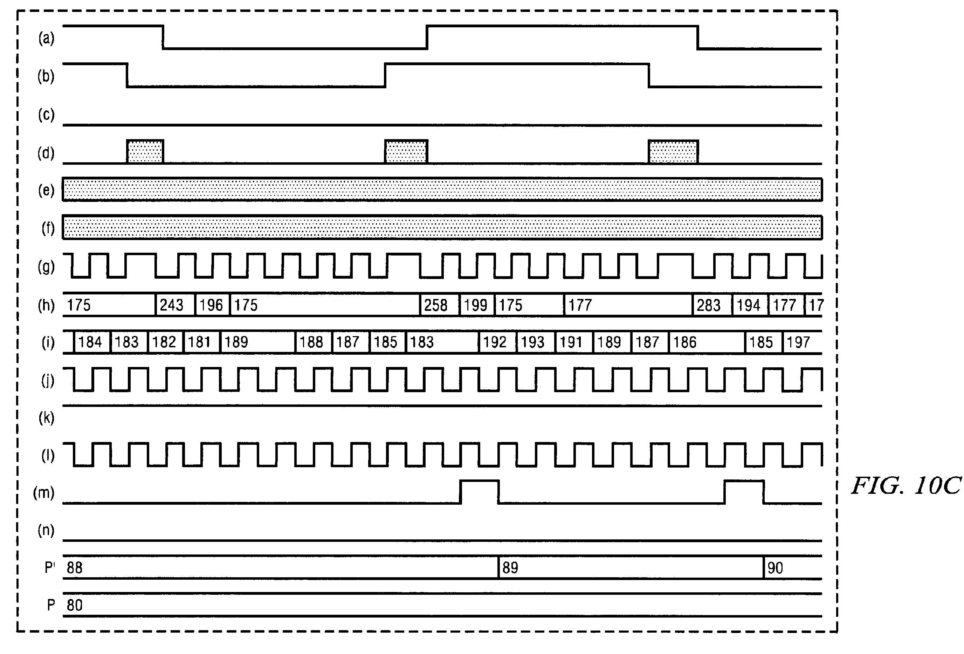

FIG. 10 is a timing diagram illustrating the functions of the various parts of the DPLL circuit of Embodiment 2. In this example, frequency division ratio M in feedback frequency divider 16 is set to "14", and preset value P for range counter 56 is set to "80".

In the case shown in FIG. 10A B, as illustrated in an enlarged view in FIG. 10B, feedback clock b lags reference clock a by more than the upper limit, and down-count enable signal n is output from phase comparator 54. As a result, each time a single-pulse signal n is input to range counter 56, the count value P' of range counter 56 is decremented one. Since corrected preset value P' is decreased with respect to pre-scaler 30 in this way, each cycle of intermediate clock g in frequency divider 18 is reduced, and the phase-locked loop works in the direction of advancing the phase of output clock j.

On the other hand, in the case shown in FIG. 10A C, as illustrated in an enlarged view in FIG. 10C, feedback clock b leads reference clock a by more than the upper limit, and up-count enable signal m is output from phase comparator 54. As a result, each time a single-pulse signal m is input to range counter 56, the count value P' of range counter 56 is increased by one. Since corrected preset value P' is increased with respect to pre-scaler 30 in this way, each cycle of intermediate clock g in frequency divider 18 is lengthened, and the phase-locked loop works in the direction of delaying the phase of output clock j.

As explained above, since up/down counter 28 of frequency divider 18 counts at the counter operating frequency $fm/4 \sim 3fm/4$ from peak to peak with respect to frequency fin of master clock MCK1, the output frequency of pre-scaler 30 is limited to the range of $fm/4P \sim 3fm/4P$. In Embodiment 2, by replacing preset value P of pre-scaler 30 with a variable corrected preset value P' ($P-\alpha \sim P+\beta$) (here, $\alpha$ and $\beta$ are positive numbers), the output frequency of pre-scaler 30 is extended to the range of $fm/4(P+\beta) \sim 3fm/4(p-\alpha)$. Here, the ratio of the upper limit to the lower limit is $3(P+\beta)/(P-\alpha)$. In said Embodiment 1, $\alpha = 0$, $\beta = 0$, so that $\mu = 3$. In Embodiment 2, for example, if $\alpha = 0.2P$ and $\beta = 0.2P$, then $\mu = 4.5$ (1.5-timer). That is, the output frequency of pre-scaler 30 that can maintain the phase locked state is extended 1.5-times, so that the lock range of said DPLL circuit is extended to 1.5-times.

In addition, in this embodiment, frequency-lock detector 58 is used. Frequency-lock detector 58 compares the period measurement value h obtained by period measurement circuit 20 for one period of each intermediate clock g output from pre-scaler 30 with moving average value i obtained by moving average value computation circuit 22, and if the error between period measurement value h and moving average value i is within a prescribed range, it is determined that a frequency-lock has been established. The detection result signal obtained by frequency-lock detector 58 is sent as the same clock selection signal as clock selection signal k from phase-lock detector 38 through AND-gate (60Z) to clock selecting circuit 40. As a result, the lock judgment becomes more reliable, and the overall control more stable. Also, in this embodiment, in said hold mode, hold control part 52 also holds the operation of range counter 56. Also, in this case, control may be performed such that during the hold time, clock j is selected by clock selecting circuit 40.

The aforementioned embodiments are merely examples of the constitution of the various parts. Various modifications can be used within the range of the present invention. For example, the phase comparison and control signal output of phase comparators 10, 54 are merely an example. Any digital scheme may be used as well. Also, the constitution and operation of intermediate oscillating frequency divider 18, especially the operation of up/down counter 28 and pre-scaler 30, are merely examples, and various other frequency division technologies may be used. The same is true for frequency measurement circuit 20, moving average value computation circuit 22, output clock generator 24, frequency division ratio control part (range counter) 56, etc. They may be realized with any digital circuit. Also, in said Embodiment 2, one may also adopt the lock range improvement technology of the DPLL circuit without using a moving average. For example, in said embodiments, one may omit period measurement circuit 20, moving average value computation circuit 22 and output clock generator 24, and use a constitution of the device with clock g generated by frequency divider 18 as the DPLL output.

## Claims

1. A digital phase-locked loop circuit adapted to generate a locked output clock at a frequency M-times, where M is an integer of 2 or more, that of the input prescribed reference clock and comprising:

   a first frequency divider (16) that divides the frequency of the output clock to 1/M to generate a feedback clock,
   a first phase comparator (10) that compares the phase of said reference clock and said feedback clock and generates a first synchronization control signal (c,d) corresponding to the phase difference,
   a second frequency divider (18) that divides a first master clock to 1/N, where N is an integer of 2 or more, by changing the value N according to said first synchronization control signal obtained by said first phase comparator and generates an intermediate clock (g) at a frequency M-times that of said reference clock,
   **characterized by**
   a period measurement circuit (20) that measures each period of said intermediate clock generated by said second frequency divider,
   a moving average value computation circuit (22) that determines the moving average value of the period of said intermediate clock on the basis of the period measurement value obtained by said period measurement circuit, and an output clock generator (24) that generates a clock having a period corresponding to the moving average value of said intermediate clock obtained by said moving average value computation circuit as said output clock.

2. The digital phase-locked loop circuit described in Claim 1 **characterized by** the fact that said second frequency divider (18) has a counter (28) for frequency division that counts said first master clock at the counter operating frequency in accordance with said first synchronization control signal from said first phase comparator.

3. The digital phase-locked loop circuit described in Claim 1 **characterized by** the fact that said second frequency divider (18) has a 1-bit counter (28) that counts said first master clock at the counter operating frequency in accordance with said first synchronization control signal from said first phase comparator, and a pre-scaler (30) that counts the clock output from said 1-bit counter and generates said intermediate clock.

4. The digital phase-locked loop circuit described in Claim 3 **characterized by** the fact that said 1-bit counter (28) has the following count modes:

   - a first count mode that counts one for every two active clock edges of said first master clocks,
   - a second count mode that counts three for every four active clock edges of said first master clock corresponding to said first synchronization control signal from said first phase comparator indicating phase delay of said feedback clock with respect to said reference clock, and
   - a third count mode that counts one for every four active clock edges of said first master clock corresponding to said first synchronization control signal from said first phase comparator indicating phase advance of said feedback clock with respect to said reference clock.

5. The digital phase-locked loop circuit described in any of Claims 1-4 **characterized by** the fact that said first phase comparator (10) uses the rising edge or falling edge of said reference clock as the first clock timing and uses the rising edge or falling edge of said feedback clock as the second clock timing to determine the lead/lag relationship between said first clock timing and said second clock timing, and outputs said first synchronization control signal during the period between said two leading/lagging clock timings.

6. The digital phase-locked loop circuit described in any of Claims 1-5 **characterized by** the fact that said period measurement circuit has a time-measuring counter that counts a second master clock.

7. The digital phase-locked loop circuit described in any of Claims 1-6 **characterized by** the fact that said moving average value computation circuit (22) has a sampling part that extracts at a prescribed shift pitch A period measurement values of the A, where A is an integer of 2 or more, consecutive intermediate clock portions obtained by said period measurement circuit, and an average value computation circuit that determines the average value of said A period measurement values extracted by said sampling part.

8. The digital phase-locked loop circuit described in any of Claims 1-7 **characterized by** the fact that said output clock generator (24) is an oscillation counter that counts a third master clock.

9. The digital phase-locked loop circuit described in any of Claims 1-8 **characterized by** the fact that it contains a feedback control part (38,40), to which are input said intermediate clock generated by said second frequency divider and said output clock generated by said clock generator, and which selects said intermediate clock or said output clock and sends it to said first frequency divider.

10. The digital phase-locked loop circuit described in Claim 9 **characterized by** the fact that said feedback control part (38,40) has a phase-lock detector (38) that detects whether the phase-locked state is established between said reference clock and said feedback clock, and said intermediate clock or said output clock is selected corresponding to the detection result of said phase-lock detector.

11. The digital phase-locked loop circuit described in Claim 10 **characterized by** the fact that said phase-lock detector (38) comprises the following parts:

an edge detector (42) that detects the rising edge or falling edge of said input clock as the first clock edge, and detects the rising edge or falling edge of said feedback clock as the second clock edge, a consecutive alternating input cycles counter (48) that counts the number of consecutive cycles with alternately input first clock edge and second clock edge, and a control signal output circuit (50) that outputs a control signal for selecting said intermediate clock from a prescribed initial state until the count value of said consecutive alternating input cycles counter exceeds a prescribed value, and a control signal for selecting said output clock after the count value of said consecutive alternating input cycles counter exceeds the prescribed value.

12. A digital phase-locked loop circuit as claimed in any preceding claim **characterized by** a second phase comparator (54) that compares the phase of said reference clock and said feedback clock to generate a second synchronization control signal corresponding to the phase difference, and a frequency division ratio control part (56) that controls and adjusts frequency division ratio N of said second frequency divider corresponding to said second synchronization control signal obtained by said second phase comparator.

13. The digital phase-locked loop circuit as claimed in Claim 12 **characterized by** the fact that said second phase comparator (54) detects the phase difference between said reference clock and said feedback clock at a sensitivity lower than that of said first phase comparator.

14. The digital phase-locked loop circuit described in Claim 13 **characterized by** the fact that said second phase comparator (54) outputs said second synchronization control signal when the phase difference between said reference clock and said feedback clock becomes greater than a prescribed value.

15. The digital phase-locked loop circuit as claimed in any of Claims 12-14 **characterized by** the fact that said frequency division ratio control part has a range counter (56) that sets the reference frequency division ratio as the initial count value for said second frequency divider, and adjusts the count value corresponding to said second synchronization control signal from said second phase comparator.

**Patentansprüche**

1. Ein digitaler Phasenregel-Schaltkreis, geeignet um einen verriegelten Ausgangstakt mit einer Frequenz zu erzeugen, die das M-fache, wobei M eine Ganzzahl von 2 oder höher ist, der durch den eingegebenen Referenztakt vorgeschriebenen Frequenz beträgt, und enthaltend:

einen ersten Frequenzteiler (16), der die Frequenz des Ausgangstaktes auf 1/M teilt, um einen Rückkopplungstakt zu erzeugen, einen ersten Phasenkomparator (10), der die Phasen des genannten Referenztaktes und des genannten Rückkopplungstaktes vergleicht und ein erstes Synchronisations-Steuersignal (c,d) erzeugt, das der Phasendifferenz entspricht,

einen zweiten Frequenzteiler (18), der einen ersten Haupttakt auf 1/N teilt, wobei N eine Ganzzahl von 2 oder höher ist, indem er den Wert N entsprechend genanntem, von genanntem ersten Phasenkomparator erhaltenen ersten Synchronisations-Steuersignal ändert, und einen Zwischentakt (g) mit einer Frequenz erzeugt, die das M-fache des genannten Referenztaktes beträgt,

**gekennzeichnet durch**

einen Perioden-Messkreis (20), der jede Periode des **durch** den zweiten Frequenzteiler erzeugten Zwischentaktes misst,
einen Gleitdurchschnitt-Berechnungsschaltkreis (22), der den Gleitdurchschnittswert der Periode des genannten Zwischentaktes anhand des vom Perioden-Messkreis erhaltenen Perioden-Messwerts bestimmt,
und einen Ausgangstaktgenerator (24), der einen Takt mit einer Periode, die dem **durch** genannten Gleitdurchschnitt-Berechnungsschaltkreis erhaltenen Gleitdurchschnittswert des genannten Zwischentaktes entspricht, als genannten Ausgangstakt erzeugt.

2. Der in Anspruch 1 beschriebene digitale Phasenregel-Schaltkreis, **dadurch gekennzeichnet, dass** der genannte zweite Frequenzteiler (18) zur Frequenzteilung einen Zähler (28) besitzt, der genannten ersten Haupttakt mit der Zähler-Arbeitsfrequenz und im Einklang mit genanntem ersten Synchronisations-Steuersignal von genanntem ersten Phasenkomparator zählt.

3. Der in Anspruch 1 beschriebene digitale Phasenregel-Schaltkreis, **dadurch gekennzeichnet, dass** der genannte zweite Frequenzteiler (18) einen 1-Bit-Zähler (28) besitzt, der genannten ersten Haupttakt mit der Zähler-Arbeitsfrequenz und im Einklang mit genanntem ersten Synchronisations-Steuersignal von genanntem ersten Phasenkomparator zählt, und einen Vorteiler (30), der den von genanntem 1-Bit-Zähler ausgegebenen Takt zählt und genannten Zwischentakt erzeugt.

4. Der in Anspruch 3 beschriebene digitale Phasenregel-Schaltkreis, **dadurch gekennzeichnet, dass** der genannte 1-Bit-Zähler (28) folgende Zählmodi besitzt:

- einen ersten Zählmodus, der eins für jede zweite anliegende Taktflanke von genanntem ersten Haupttakt zählt,
- einen zweiten Zählmodus, der entsprechend dem genannten ersten Synchronisations-Steuersignal von genanntem erstem Phasenkomparator, das eine Phasenverzögerung des genannten Rückkopplungstaktes bezüglich dem genannten Referenztakt anzeigt, drei für jede vierte anliegende Taktflanke von genanntem ersten Haupttakt zählt, und
- einen dritten Zählmodus, der entsprechend dem genannten ersten Synchronisations-Steuersignal von genanntem ersten Phasenkomparator, das eine Phasenvoreilung des genannten Rückkopplungstakts bezüglich dem genannten Referenztakt anzeigt, eins für jede vierte anliegende Taktflanke von genanntem erstem Haupttakt zählt.

5. Der in einem der Ansprüche 1-4 beschriebene digitale Phasenregel-Schaltkreis, **dadurch gekennzeichnet, dass** der genannte erste Phasenkomparator (10) die steigende Flanke oder die fallende Flanke des genannten Referenztaktes als erste Takt-Zeitlage verwendet und die steigende Flanke oder die fallende Flanke des genannten Rückkopplungstaktes als zweite Takt-Zeitlage verwendet, um das Vorlauf/Nachlauf-Verhältnis zwischen genannter erster Takt-Zeitlage und genannter zweiter Takt-Zeitlage zu bestimmen, und das genannte erste Synchronisations-Steuersignal während der Zeitspanne zwischen genannten beiden Takt-Zeitlagen, Voreilen und Nachlaufen, ausgibt.

6. Der in einem der Ansprüche 1-5 beschriebene digitale Phasenregel-Schaltkreis, **dadurch gekennzeichnet, dass** der genannte Perioden-Messkreis einen zeitmessenden Zähler besitzt, der einen zweiten Haupttakt zählt.

7. Der in einem der Ansprüche 1-6 beschriebene digitale Phasenregel-Schaltkreis, **dadurch gekennzeichnet, dass** der genannte Gleitdurchschnitt-Berechnungsschaltkreis (22) ein Abtast-Element besitzt, das mit einem vorgeschriebenen Verschiebungs-Schritt A Perioden-Messwerte von A, wobei A eine Ganzzahl von 2 oder höher ist, aufeinanderfolgende Zwischentakt-Stellen, erhalten von genanntem Perioden-Messkreis, gewinnt, und einen Gleitdurchschnitt-Berechnungsschaltkreis, der den Durchschnittswert der genannten A Perioden-Messwerte, von genanntem Abtast-Element gewonnen, ermittelt.

8. Der in einem der Ansprüche 1-7 beschriebene digitale Phasenregel-Schaltkreis, **dadurch gekennzeichnet, dass** genannter Ausgangstaktgenerator (24) ein Schwingungszähler ist, der einen dritten Haupttakt zählt.

9. Der in einem der Ansprüche 1-8 beschriebene digitale Phasenregel-Schaltkreis, **dadurch gekennzeichnet, dass** er einen Rückkopplungs-Steuerteil (38,40) enthält, in den genannter Zwischentakt, von genanntem zweiten Frequenzteiler erzeugt, und genannter Ausgangstakt, von genanntem Ausgangstaktgenerator erzeugt, eingegeben werden und der genannten Zwischentakt oder genannten Ausgangstakt auswählt und an genannten ersten Frequenzteiler sendet.

10. Der in Anspruch 9 beschriebene digitale Phasenregel-Schaltkreis, **dadurch gekennzeichnet, dass** genannter Rückkopplungs-Steuerteil (38,40) einen Phasenverriegelungs-Detektor (38) besitzt, der detektiert, ob der phasenverriegelte Zustand zwischen genanntem Referenztakt und genanntem Rückkopplungtakt hergestellt ist, und der genannte Zwischentakt oder der genannte Ausgangstakt entsprechend dem Detektionsergebnis von genanntem Phasenverriegelungs-Detektor gewählt wird.

11. Der in Anspruch 10 beschriebene digitale Phasenregel-Schaltkreis, **dadurch gekennzeichnet, dass** genannter Phasenverriegelungs-Detektor (38) folgende Bestandteile enthält:

einen Flankendetektor (42), der die steigende Flanke oder fallende Flanke von genanntem Eingangstakt als die erste Taktflanke detektiert, und der die steigende Flanke oder fallende Flanke von genanntem Rückkopplungstakt als die zweite Taktflanke detektiert,
einen Zähler fortlaufend alternierender Eingangs-Zyklen (48), der die Anzahl an fortlaufenden Zyklen mit alternierend eingehender erster Taktflanke und zweiter Taktflanke zählt,
und einen Steuersignal-Ausgabeschaltkreis (50), der ein Steuersignal ausgibt zum Auswählen des genannten Zwischentaktes ab einem vorgeschriebenen Anfangszustand und bis der Zählwert des genannten Zählers fortlaufend alternierender Eingangs-Zyklen einen vorgeschriebenen Wert überschreitet, und ein Steuersignal zum Auswählen des genannten Ausgangstaktes, nachdem der Zählwert des genannten Zählers fortlaufend alternierender Eingangs-Zyklen den vorgeschriebenen Wert überschreitet.

12. Ein digitaler Phasenregel-Schaltkreis wie in einem der vorangehenden Ansprüchen beansprucht, **gekennzeichnet durch**
einen zweiten Phasenkomparator (54), der die Phasen des genannten Referenztaktes und des genannten Rückkopplungstaktes vergleicht, um ein zweites Synchronisations-Steuersignal zu erzeugen, das der Phasendifferenz entspricht,
und einen Frequenzteilungsverhältnis-Steuerteil (56), der das Frequenzteilungsverhältnis N von genanntem zweiten Frequenzteiler entsprechend genanntem zweiten Synchronisations-Steuersignal, erhalten von genanntem zweiten Phasenkomparator, steuert und einstellt.

13. Der in Anspruch 12 beschriebene digitale Phasenregel-Schaltkreis, **dadurch gekennzeichnet, dass** genannter zweiter Phasenkomparator (54) die Phasendifferenz zwischen genanntem Referenztakt und genanntem Rückkopplungtakt mit einer geringeren Empfindlichkeit als der des genannten ersten Phasenkomparators detektiert.

14. Der in Anspruch 13 beschriebene digitale Phasenregel-Schaltkreis, **dadurch gekennzeichnet, dass** genannter zweiter Phasenkomparator (54) genanntes zweites Synchronisations-Steuersignal ausgibt, wenn die Phasendifferenz zwischen genanntem Referenztakt und genanntem Rückkopplungstakt größer als ein vorgeschriebener Wert wird.

15. Der in einem der Ansprüche 12-14 beschriebene digitale Phasenregel-Schaltkreis, **dadurch gekennzeichnet, dass** der Frequenzteilungsverhältnis-Steuerteil einen Bereichszähler (56) besitzt, der das Referenzfrequenz-Teilungsverhältnis für genannten zweiten Frequenzteiler als Anfangs-Zählwert setzt und den Zählwert entsprechend dem genannten zweiten Synchronisations-Steuersignal von genanntem zweiten Phasenkomparator anpasst.

**Revendications**

1. Circuit de boucle à verrouillage de phase numérique adapté pour générer une horloge de sortie verrouillée à une fréquence égale à M fois, où M est un nombre entier supérieur ou égal à 2, celle de l'horloge de référence prescrite en entrée et comprenant :

un premier diviseur de fréquence (16) qui divise la fréquence de l'horloge de sortie à 1 / M pour générer une horloge de rétroaction,

un premier comparateur de phase (10) qui compare la phase de ladite horloge de référence et celle de ladite horloge de rétroaction et génère un premier signal de commande de synchronisation (c, d) correspondant à la différence de phase,

un deuxième diviseur de fréquence (18) qui divise une première horloge maître à 1 / N, où N est un nombre entier supérieur ou égal à 2, en modifiant la valeur N selon ledit premier signal de commande de synchronisation obtenu par ledit premier comparateur de phase, et génère une horloge intermédiaire (g) à une fréquence qui est égale à M fois celle de ladite horloge de référence,

**caractérisé par**

un circuit de mesure de période (20) qui mesure chaque période de ladite horloge intermédiaire générée par ledit deuxième diviseur de fréquence,

un circuit de calcul de valeur moyenne mobile (22) qui détermine la valeur moyenne mobile de la période de ladite horloge intermédiaire sur la base de la valeur de mesure de période obtenue par ledit circuit de mesure de période,

et un générateur d'horloge de sortie (24) qui génère une horloge dont la période correspond à la valeur moyenne mobile de ladite horloge intermédiaire obtenue par ledit circuit de calcul de valeur moyenne mobile en tant que ladite horloge de sortie.

2. Circuit de boucle à verrouillage de phase numérique selon la revendication 1, **caractérisé par le fait que** ledit deuxième diviseur de fréquence (18) possède un compteur (28) de division de fréquence qui compte ladite première horloge maître à la fréquence de fonctionnement du compteur selon ledit premier signal de commande de synchronisation issu dudit premier comparateur de phase.

3. Circuit de boucle à verrouillage de phase numérique selon la revendication 1, **caractérisé par le fait que** ledit deuxième diviseur de fréquence (18) possède un compteur à 1 bit (28) qui compte ladite première horloge maître à la fréquence de fonctionnement du compteur selon ledit premier signal de commande de synchronisation provenant dudit premier comparateur de phase, et un diviseur préalable (30) qui compte la sortie d'horloge provenant dudit compteur à 1 bit et génère ladite horloge intermédiaire.

4. Circuit de boucle à verrouillage de phase numérique selon la revendication 3, **caractérisé par le fait que** ledit compteur à 1 bit (28) présente les modes de comptage suivants:

- un premier mode de comptage qui compte un tous les deux fronts d'horloge actifs de ladite première horloge maître;

- un deuxième mode de comptage qui compte trois tous les quatre fronts d'horloge actifs de ladite première horloge maître correspondant audit premier signal de commande de synchronisation provenant dudit premier comparateur de phase indiquant le retard de phase de ladite horloge de rétroaction par rapport à ladite horloge de référence, et

- un troisième mode de comptage qui compte un tous les quatre fronts d'horloge actifs de ladite première horloge maître correspondant audit premier signal de commande de synchronisation provenant dudit premier comparateur de phase indiquant l'avance de phase de ladite horloge de rétroaction par rapport à ladite horloge de référence.

5. Circuit de boucle à verrouillage de phase numérique selon l'une quelconque des revendications 1 à 4, **caractérisé par le fait que** ledit premier comparateur de phase (10) utilise le front montant ou le front descendant de ladite horloge de référence en tant que première synchronisation d'horloge, et utilise le front montant ou le front descendant de ladite horloge de rétroaction en tant que deuxième synchronisation d'horloge pour déterminer la relation d'avance / de retard entre ladite première synchronisation d'horloge et ladite deuxième synchronisation d'horloge, et délivre en sortie ledit premier signal de commande de synchronisation au cours de la période entre lesdites deux synchronisations d'horloge en avance / en retard.

6. Circuit de boucle à verrouillage de phase numérique selon l'une quelconque des revendications 1 à 5, **caractérisé par le fait que** ledit circuit de mesure de période possède un compteur de mesure du temps qui compte une deuxième horloge maître.

**7.** Circuit de boucle à verrouillage de phase numérique selon l'une quelconque des revendications 1 à 6, **caractérisé par** le fait est que ledit circuit de calcul de valeur moyenne mobile (22) présente une partie d'échantillonnage qui extrait, selon un pas de décalage prescrit, A valeurs de mesure de période des A, où A est un nombre entier supérieur ou égal à 2, parties d'horloge intermédiaires consécutives obtenues par ledit circuit de mesure de période, et un circuit de calcul de valeur moyenne qui détermine la valeur moyenne desdites A valeurs de mesure de période extraites par ladite partie d'échantillonnage.

**8.** Circuit de boucle à verrouillage de phase numérique selon l'une quelconque des revendications 1 à 7, **caractérisé par le fait que** ledit générateur d'horloge de sortie (24) est un compteur d'oscillation qui compte une troisième horloge maître.

**9.** Circuit de boucle à verrouillage de phase numérique selon l'une quelconque des revendications 1 à 8, **caractérisé par le fait qu'**il contient une partie de commande de rétroaction (38, 40), dans laquelle sont entrées ladite horloge intermédiaire générée par ledit deuxième diviseur de fréquence, et ladite horloge de sortie générée par ledit générateur d'horloge, et qui sélectionne ladite horloge intermédiaire ou ladite horloge de sortie et l'envoie audit premier diviseur de fréquence.

**10.** Circuit de boucle à verrouillage de phase numérique selon la revendication 9, **caractérisé par le fait que** ladite partie de commande de rétroaction (38, 40) possède un détecteur de verrouillage de phase (38) qui détecte si l'état verrouillé en phase est établi entre ladite horloge de référence et ladite horloge de rétroaction, et ladite horloge intermédiaire ou ladite horloge de sortie est sélectionnée en fonction du résultat de la détection dudit détecteur de verrouillage de phase.

**11.** Circuit de boucle à verrouillage de phase numérique selon la revendication 10, **caractérisé par le fait que** ledit détecteur de verrouillage de phase (38) comprend les parties suivantes :

- un détecteur de front (42) qui détecte le front montant ou le front descendant de ladite horloge d'entrée en tant que premier front d'horloge, et détecte le front montant ou le front descendant de ladite horloge de rétroaction en tant que deuxième front d'horloge,
- un compteur de cycles d'entrée en alternance consécutifs (48) qui compte le nombre de cycles consécutifs avec alternativement en entrée le premier front d'horloge et le deuxième front d'horloge, et
- un circuit de sortie de signal de commande (50) qui délivre en sortie un signal de commande pour sélectionner ladite horloge intermédiaire à partir d'un état initial prescrit jusqu'à ce que la valeur de comptage dudit compteur de cycles d'entrée en alternance consécutifs dépasse une valeur prescrite, et un signal de commande pour sélectionner ladite horloge de sortie une fois que la valeur de comptage dudit compteur de cycles d'entrée en alternance consécutifs a dépassé la valeur prescrite.

**12.** Circuit de boucle à verrouillage de phase numérique selon l'une quelconque des revendications précédentes, **caractérisé par** :

- un deuxième comparateur de phase (54) qui compare la phase de ladite horloge de référence et celle de ladite horloge de rétroaction pour générer un deuxième signal de commande de synchronisation correspondant à la différence de phase, et
- une partie de commande du rapport de division de fréquence (56) qui commande et ajuste le rapport de division de fréquence N dudit deuxième diviseur de fréquence correspondant audit deuxième signal de commande de synchronisation obtenu par ledit deuxième comparateur de phase.

**13.** Circuit de boucle à verrouillage de phase numérique selon la revendication 12, **caractérisé par le fait que** ledit deuxième comparateur de phase (54) détecte la différence de phase entre ladite horloge de référence et ladite horloge de rétroaction à une sensibilité plus faible que celle dudit premier comparateur de phase.

**14.** Circuit de boucle à verrouillage de phase numérique selon la revendication 13, **caractérisé par le fait que** ledit deuxième comparateur de phase (54) délivre en sortie ledit deuxième signal de commande de synchronisation lorsque la différence de phase entre ladite horloge de référence et ladite horloge de rétroaction devient supérieure à une valeur prescrite.

**15.** Circuit de boucle à verrouillage de phase numérique selon l'une quelconque des revendications 12 à 14, **caractérisé par le fait que** ladite partie de commande du rapport de division de fréquence possède un compteur de plage (56) qui fixe le rapport de division de fréquence de référence comme étant la valeur de comptage initiale dudit deuxième diviseur de fréquence, et ajuste la valeur de comptage correspondant audit deuxième signal de commande de synchronisation provenant dudit deuxième comparateur de phase.

FIG. 1

FIG. 2

## FIG. 3A

## FIG. 3B

FIG. 4C

FIG. 4B

FIG. 4A

JITTER

(a)
(b)
(c)
(d)
(e)
(f)
(g)
(h) 175 | 171 | 175 | 180 | 175 | 195 | 175 | 179 | 205 | 175
(i) * | 177 | 176 | 175 | 177 | 176 | 175 | 178 | 177
(j)
(k)
(l)

FIG. 4B

FIG. 4C

*FIG. 5*

FEEDBACK CLOCK    REFERENCE CLOCK

(b)    (a)

38

EDGE DETECTOR — 42

44

FEEDBACK CLOCK FALLING EDGE (B)

S    F/F    R

REFERENCE CLOCK RISING EDGE (A)

S[5]

COUNTER CONTROLLER — 46

RESET (D)    COUNT ENABLE (C)

STATE COUNTER — 48

S[4:0]

⌈K⌋ → COMPARATOR — 50

(k)

*FIG. 6*

INITIAL STATE

3Fh

00h    20h

01h    21h

02h    22h

03h    23h

o o o    o o o    o o o

1Dh    3Dh

1Eh    3Eh

RISING EDGE OF REFERENCE CLOCK

FALLING EDGE OF FEEDBACK CLOCK

(XXh) S[5:0]=XXh

*FIG. 7*

FIG. 8

EP 1 513 257 B1

FIG. 9

EP 1 513 257 B1

FIG. 10A
FIG. 10B
FIG. 10C

EP 1 513 257 B1

P' 90 89 88        89 90 91 92

P 80

FIG. 10B

EP 1 513 257 B1

FIG. 10C

EP 1 513 257 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 10022486